(19) Europäisches Patentamt
European Patent Office
Office européen des brevets

(11) **EP 4 553 521 A1**

(12) **EUROPEAN PATENT APPLICATION**
published in accordance with Art. 153(4) EPC

(43) Date of publication:
**14.05.2025 Bulletin 2025/20**

(21) Application number: 23835426.0

(22) Date of filing: **29.06.2023**

(51) International Patent Classification (IPC):
*G01R 31/389* (2019.01)   *G01N 27/72* (2006.01)
*G01R 33/02* (2006.01)   *H01M 10/48* (2006.01)

(52) Cooperative Patent Classification (CPC):
G01N 27/72; G01R 31/389; G01R 33/02;
H01M 10/48; Y02E 60/10

(86) International application number:
**PCT/JP2023/024264**

(87) International publication number:
**WO 2024/009894 (11.01.2024 Gazette 2024/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.07.2022 JP 2022109689**

(71) Applicant: **Integral Geometry Science Inc.
Kobe-shi, Hyogo, 657-8501 (JP)**

(72) Inventors:
• **SUZUKI Shogo
Kobe-shi, Hyogo 657-8501 (JP)**

• **MATSUDA Seiju
Kobe-shi, Hyogo 657-8501 (JP)**
• **MIMA Yuki
Kobe-shi, Hyogo 657-8501 (JP)**
• **NISHIMURA Yutaro
Kobe-shi, Hyogo 657-8501 (JP)**
• **OKADA Hideaki
Kobe-shi, Hyogo 657-8501 (JP)**
• **KIMURA Kenjiro
Kobe-shi, Hyogo 657-8501 (JP)**
• **KIMURA Noriaki
deceased (JP)**

(74) Representative: **Novagraaf International SA
Chemin de l'Echo 3
1213 Onex, Geneva (CH)**

(54) **MEASUREMENT DEVICE AND MEASUREMENT METHOD**

(57)     A measurement apparatus (10) is an apparatus that measures a secondary battery (20). The measurement apparatus (10) includes a voltage application unit (140), a switching unit (120), a measurement unit (160), and a processing unit (180). The voltage application unit (140) applies a predetermined voltage determined based on an open circuit voltage of the secondary battery (20), to the secondary battery (20). The switching unit (120) switches between a first state in which the predetermined voltage is applied to the secondary battery (20) and a second state in which the secondary battery is open. The measurement unit (160) measures a transient response of an external magnetic field of the secondary battery (20) when switching the first state to the second state. The processing unit (180) generates information on an inside of the secondary battery (20) by using a measurement result of the measurement unit (160).

FIG. 1

**Description**

TECHNICAL FIELD

The present invention relates to a measurement apparatus and a measurement method.

BACKGROUND ART

With widespread use of a rechargeable and dischargeable secondary battery, a non-destructive inspection technique has become increasingly important.

Patent Document 1 discloses that a magnetic field around a battery is measured in a state where a current flows, and a conductivity distribution in the battery is derived.

Patent Document 2 discloses that a magnetic field outside a battery is measured in a state where an external voltage on which an AC voltage is superimposed is applied to the battery, and a magnetic field distribution or a current distribution inside the battery is derived.

RELATED DOCUMENT

PATENT DOCUMENT

Patent Document 1: International Publication No. WO2015/136931
Patent Document 2: International Publication No. WO2015/136930

SUMMARY OF THE INVENTION

TECHNICAL PROBLEM

However, the technique of Patent Document 1 has a problem in that an internal state of the battery changes because charging or discharging progresses during measurement. In addition, the technique of Patent Document 2 has a problem in that it is difficult to detect a minute defect in the battery.

In view of the above-described problems, the present invention provides a new technique for measuring a secondary battery.

SOLUTION TO PROBLEM

According to one aspect of the present invention, the following measurement apparatus and measurement method are provided.

1. A measurement apparatus that measures a secondary battery, including: a voltage application unit that applies a predetermined voltage that is determined based on an open circuit voltage of the secondary battery, to the secondary battery; a switching unit that switches between a first state in which the predetermined voltage is applied to the secondary battery and a second state in which the secondary battery is open; a measurement unit that measures a transient response of an external magnetic field of the secondary battery when switching from the first state to the second state; and a processing unit that generates information on an inside of the secondary battery by using a measurement result of the measurement unit.

2. The measurement apparatus according to the above 1 item, further including: a control unit that controls the voltage application unit and the measurement unit, in which the measurement unit includes a sensor unit and a sensor drive unit, and the control unit controls the voltage application unit and the measurement unit such that a determination step of determining a fixed input value to the sensor unit which is used for canceling at least a part of a noise magnetic field and a measurement step of measuring the transient response in a state where the fixed input value is input to the sensor unit are performed in this order.

3. The measurement apparatus according to the above 2 item, in which, in the determination step, the control unit controls the voltage application unit and the measurement unit such that the sensor drive unit performs feedback control of an input value to the sensor unit so that an output of the sensor unit approaches a reference level in a state where a voltage corresponding to the open circuit voltage is applied to the secondary battery, thereby determining the fixed input value.

4. The measurement apparatus according to the above 2 or 3 item, in which the secondary battery includes a ferromagnetic material.

5. The measurement apparatus according to any one of the above 1 to 4 items, in which the measurement unit measures the transient response at a plurality of positions in one or more planes outside the secondary battery, and the processing unit generates a map indicating internal information of the secondary battery.

6. The measurement apparatus according to the above 5 item, in which the measurement unit includes a plurality of sensor elements arranged in a matrix.

7. The measurement apparatus according to any one of the above 1 to 6 items, in which the processing unit determines whether or not the measured secondary battery has an abnormality by using the measurement result of the measurement unit, and outputs a notification in a case where it is determined that the secondary battery has an abnormality.

8. The measurement apparatus according to any one of the above 1 to 7 items, in which the voltage application unit applies the predetermined voltage to the secondary battery by using a periodic signal, and the switching unit switches between the first state and the second state by using a periodic signal having a frequency that is an integral multiple of a frequency of the periodic signal used by the voltage application unit.

9. The measurement apparatus according to any one of the above 1 to 8 items, in which the measurement unit measures magnetic field components in two directions orthogonal to each other as the transient response, and the processing unit generates a conductivity distribution inside the secondary battery by using the magnetic field components in the two directions.

10. A measurement method of measuring a secondary battery, including: switching between a first state in which a predetermined voltage that is determined based on an open circuit voltage of the secondary battery is applied to the secondary battery and a second state in which the secondary battery is open; measuring a transient response of an external magnetic field of the secondary battery when switching from the first state to the second state; and generating information on an inside of the secondary battery by using a measurement result of the transient response.

ADVANTAGEOUS EFFECTS OF INVENTION

According to the present invention, it is possible to provide a new technique for measuring a secondary battery.

BRIEF DESCRIPTION OF THE DRAWINGS

Fig. 1 is a diagram illustrating a functional configuration of a measurement apparatus according to a first embodiment.
Fig. 2 is a cross-sectional view illustrating a structure of a secondary battery.
Fig. 3 is a schematic diagram illustrating a state in which the secondary battery is measured by a measurement apparatus.
Fig. 4 is a diagram showing a modification example of a sensor unit.
Fig. 5 is a diagram describing a voltage applied to the secondary battery by the measurement apparatus.
Fig. 6 is a diagram describing a voltage applied to the secondary battery by the measurement apparatus.
Fig. 7 is a diagram illustrating a computer for implementing the measurement apparatus.
Fig. 8 is a diagram illustrating a configuration of a switching unit and a voltage application unit included in the measurement apparatus according to a second embodiment.
Fig. 9 is a diagram describing an operation of the measurement apparatus according to the second embodiment.
Figs. 10A to 10G are diagrams showing an example of a case where a frequency of a periodic signal output by a multiplier is changed.
Fig. 11 is a diagram illustrating a flow of a signal in the measurement unit according to a third embodiment.
Fig. 12 is a diagram illustrating a hardware configuration of the measurement unit according to the third embodiment.
Fig. 13 is a diagram illustrating a configuration of the measurement apparatus according to the third embodiment.
Fig. 14 is a schematic cross-sectional view showing a structure of a secondary battery as a measurement target.
Fig. 15 is a diagram showing a measurement area and a position of a defect with respect to a photograph of the secondary battery.
Fig. 16 is a diagram showing a map generated using measurement results of a transient response of a magnetic field.

DESCRIPTION OF EMBODIMENTS

Hereinafter, embodiments of the present invention will be described with reference to the drawings. In all drawings, the same components are denoted by the same reference numerals, and description thereof will not be repeated. In the following description, except for a case where particular description is provided, each component of each apparatus represents a block of a functional unit rather than a configuration of a hardware unit.

(First Embodiment)

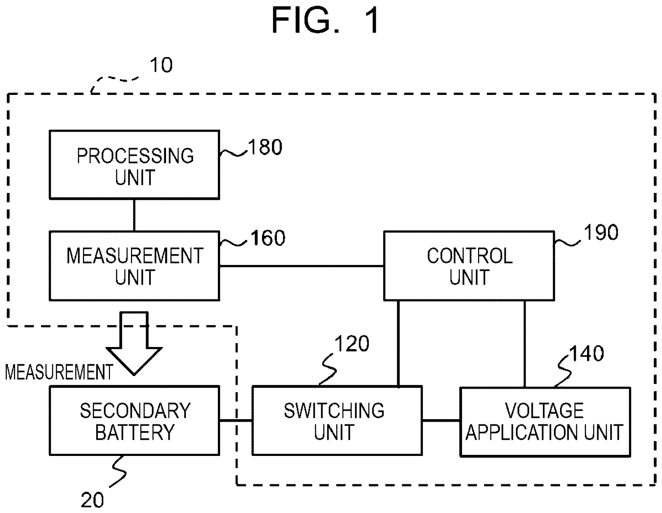

Fig. 1 is a diagram illustrating a functional configuration of a measurement apparatus 10 according to a first embodiment. The measurement apparatus 10 according to the present embodiment is an apparatus that measures a secondary battery 20. The measurement apparatus 10 includes a voltage application unit 140, a switching unit 120, a measurement unit 160, and a processing unit 180. The voltage application unit 140 applies a predetermined voltage that is determined based on an open circuit voltage (OCV) of the secondary battery 20, to the secondary battery 20. The switching unit 120 switches between a first state in which the predetermined voltage is applied to the secondary battery 20 and a second state in which the secondary battery is open. The measurement unit 160 measures a transient response of an external magnetic field of the secondary battery 20 when switching from the first state to the second state. The processing unit 180 generates information on an inside of the secondary battery 20 by using a measurement result of the measurement unit 160. The details will be described below.

In the example of this figure, the measurement apparatus 10 further includes a control unit 190. In the example of this figure, the control unit 190 controls the switching unit 120, the voltage application unit 140, and the measurement unit 160.

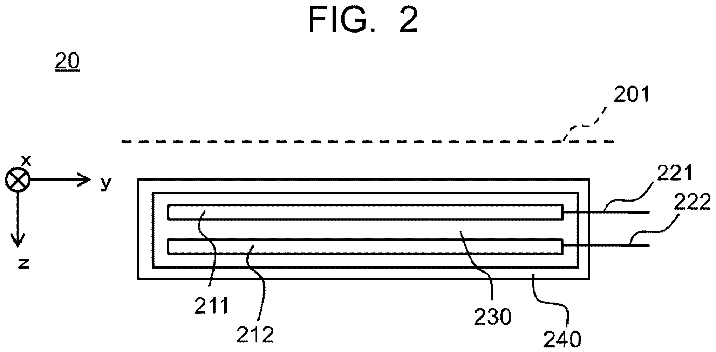

Fig. 2 is a cross-sectional view illustrating a structure of the secondary battery 20. A measurement target of the measurement apparatus 10 is the secondary battery 20. The measurement apparatus 10 is used to detect, for example, a defect such as a short-circuit portion in the secondary battery 20. The secondary battery 20 is not particularly limited, and is, for example, a lead storage battery, a nickel-cadmium storage battery, a lithium ion battery, a sodium ion battery, or the like. The secondary battery 20 includes a positive electrode 211, a negative electrode 212, an electrolyte 230, a package 240, a positive electrode terminal 221, and a negative electrode terminal 222. The positive electrode 211 and the negative electrode 212 are plate-shaped, film-shaped, or layer-shaped electrodes, and are parallel to each other. The secondary battery 20 may include a plurality of the positive electrodes 211 and a plurality of the negative electrodes 212. The electrolyte 230 is located between the positive electrode 211 and the negative electrode 212. The electrolyte 230 may be a liquid, a solid, or a gel. In addition, a separator may be further provided between the positive electrode 211 and the negative electrode 212. The positive electrode 211, the negative electrode 212, and the electrolyte 230 are covered and sealed with the package 240. The package 240 is, for example, a metal package.

One end of the positive electrode terminal 221 is electrically connected to the positive electrode 211 inside the package 240, and the other end of the positive electrode terminal 221 is located outside the package 240. In a case where the secondary battery 20 has the plurality of positive electrodes 211, the positive electrode terminal 221 is electrically connected to the plurality of positive electrodes 211. One end of the negative electrode terminal 222 is electrically connected to the negative electrode 212 inside the package 240, and the other end of the negative electrode terminal 222 is located outside the package 240. In a case where the secondary battery 20 has the plurality of negative electrodes 212, the negative electrode terminal 222 is electrically connected to the plurality of negative electrodes 212. The positive electrode terminal 221 and the negative electrode terminal 222 are, for example, tabs. Application of the voltage to the secondary battery 20 means that the voltage is applied between the positive electrode terminal 221 and the negative electrode terminal 222.

The measurement unit 160 of the measurement apparatus 10 is configured to measure, for example, a magnetic field in a plane 201 outside the secondary battery 20. The plane 201 is a plane parallel to principal surfaces of the positive electrode 211 and the negative electrode 212. A distance between the outermost surface of the secondary battery 20 and the plane 201 is not particularly limited, but is, for example, equal to or more than 0.01 mm and equal to or less than 100 mm. When the distance is within this range, a magnetic field from the secondary battery 20 can be accurately measured, and the measurement can be stably performed while avoiding contact between a sensor unit 161 which will be described below and the secondary battery 20. Hereinafter, a stacking direction between the positive electrode terminal 221 and the negative electrode 212 is referred to as a z direction, and two directions that are all orthogonal to the z direction and are orthogonal to each other are referred to as an x direction and a y direction.

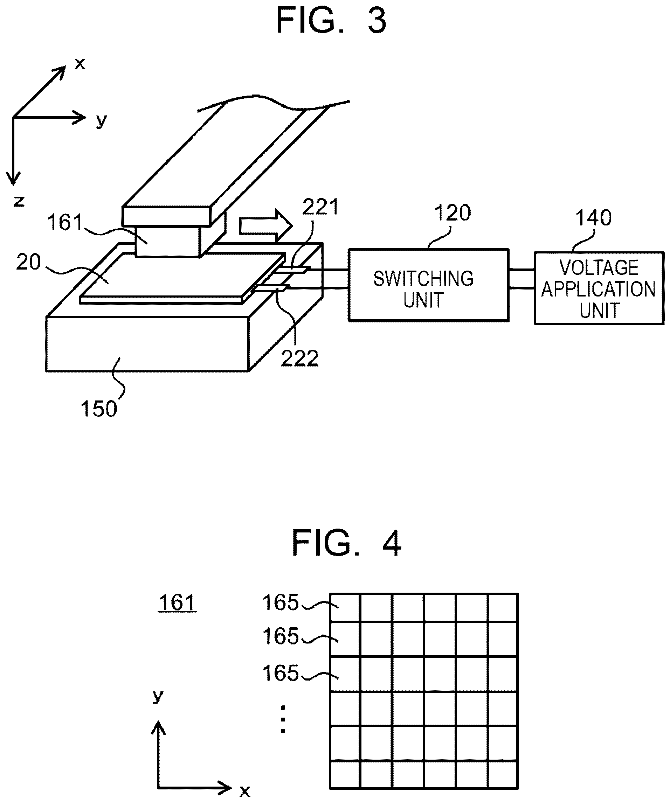

Fig. 3 is a schematic diagram illustrating a state in which the secondary battery 20 is measured by the measurement apparatus 10. At the time of measurement by the measurement apparatus 10, at least one of the positive electrode terminal 221 and the negative electrode terminal 222 of the secondary battery 20 is connected to the voltage application unit 140 through the switching unit 120. In this manner, a configuration is provided in which a voltage can be applied between the positive electrode terminal 221 and the negative electrode terminal 222, that is, to the secondary battery 20. One of the positive electrode terminal 221 and the negative electrode terminal 222 may be grounded.

It is preferable that the measurement unit 160 measures a magnetic field at a plurality of positions. The measurement unit 160 includes the sensor unit 161, and measures a magnetic field (for example, a magnetic flux density) at a position of the sensor unit 161. The sensor unit 161 includes any magnetic sensor such as a coil, a Hall element, an optically pumping magnet sensor, a diamond magnet sensor, a magnetic impedance sensor, or a magnetoresistance effect element.

In the example of this figure, the measurement unit 160 scans the outside of the secondary battery 20 one-dimensionally or two-dimensionally with the sensor unit 161 included in the measurement unit 160. By doing so, the measurement unit 160 measures the magnetic field at a plurality of measurement positions, that is, at a plurality of points (x,y) in the plane 201. The plurality of measurement positions are preferably distributed two-dimensionally in the plane 201. In the example of this figure, the secondary battery 20 is disposed on a stage 150. The stage 150 can drive the secondary battery 20 in the x direction and in the y direction. Alternatively, the stage 150 may be capable of driving the secondary battery 20 in the x direction, in the y direction, and in the z direction. The stage 150 drives the secondary battery 20, so that the sensor unit 161 can sequentially perform the measurement at the plurality of positions. Note that the stage 150 may be configured to drive the sensor unit 161 instead of driving the secondary battery 20. The control unit 190 can further control the stage 150 such that the measurement unit 160 measures a transient response of the magnetic field at the plurality of positions in the plane 201.

Fig. 4 is a diagram showing a modification example of the sensor unit 161. In the example of this figure, the measurement unit 160 includes a plurality of sensor elements 165 arranged in a matrix in the sensor unit 161. The sensor element 165 may be any magnetic sensor such as a coil, a Hall element, an optically pumping magnet sensor, a diamond magnet sensor, a magnetic impedance sensor, or a magnetoresistance effect element. The plurality of sensor elements 165 are integrated. According to the present modification example, instead of performing measurement at a plurality of positions by scanning with the sensor unit 161 as shown in Fig. 3, the plurality of sensor elements 165 can perform measurement at a plurality of positions simultaneously. Therefore, measurement time can be significantly shortened. In the example of this figure, the plurality of sensor elements 165 are two-dimensionally arranged in a matrix. Therefore, data of measurement points two-dimensionally arranged in the plane 201 can be obtained. Note that the plurality of sensor elements 165 may be one-dimensionally arranged in a line. In this case, the plurality of sensor elements 165 may be moved in a direction perpendicular to a direction in which the plurality of sensor elements 165 are arranged to perform the measurement. With this method as well, data at the measurement points (measurement positions) arranged two-dimensionally in the plane 201 can be obtained.

Returning to Fig. 1, each functional configuration unit of the measurement apparatus 10 will be described. The direction of the magnetic field measured by the measurement unit 160 may be one direction, may be two directions, or may be three directions. The measurement unit 160 measures, for example, a component of the magnetic field in one or more directions of the x direction, the y direction, and the z direction. In particular, the measurement unit 160 preferably measures at least one of a component in the x direction and a component in the y direction of the magnetic field vector. In a case where the sensor unit 161 includes a coil, the measurement unit 160 can measure a component in an axial direction of the coil, and can measure components of the magnetic field in a plurality of directions by changing an orientation of the coil or using a plurality of coils.

The voltage application unit 140 includes at least a DC voltage source. The switching unit 120 switches whether or not to apply an output voltage of the voltage application unit 140 to the secondary battery 20. The switching unit 120 is, for example, a switch or a transistor.

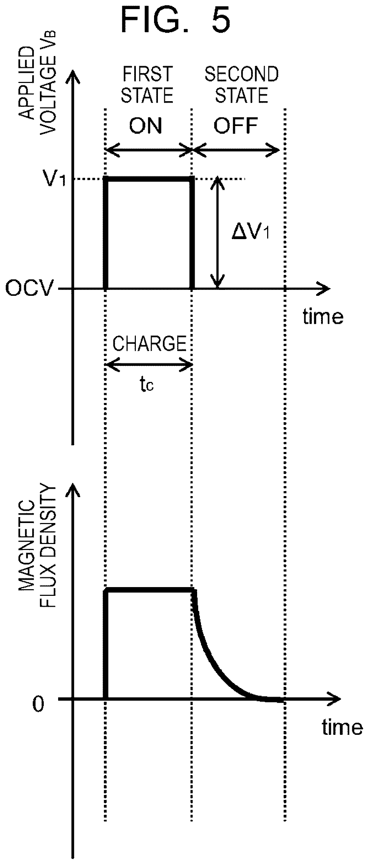

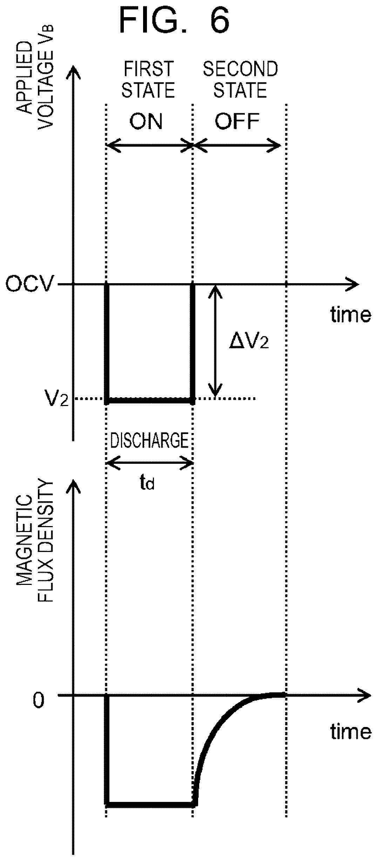

Figs. 5 and 6 are diagrams describing a voltage applied to the secondary battery 20 by the measurement apparatus 10. In each of Figs. 5 and 6, a waveform of an applied voltage $V_B$ to the secondary battery 20 is shown in an upper part, and a magnetic flux density leaking to the outside of the secondary battery 20 is shown in a lower part.

For example, in the example of Fig. 5, the voltage application unit 140 outputs a predetermined voltage $V_1$. The predetermined voltage $V_1$ is a voltage determined based on an open circuit voltage. For example, $\Delta V_1$, which is a difference between the open circuit voltage and the output voltage of the voltage application unit 140, is predetermined, and $\Delta V_1$ is added to the open circuit voltage of the secondary battery 20 to be measured, thereby deciding the voltage $V_1$ with respect to the secondary battery 20. The open circuit voltage of the secondary battery 20 can be confirmed by separate measurement prior to the measurement. When the switching unit 120 is in an ON state, the output voltage of the voltage application unit 140 is applied to the secondary battery 20. That is, the time when the switching unit 120 is in an ON state is the first state. In the example of this figure, the secondary battery 20 is charged in the first state. On the other hand, when the switching unit 120 is in an OFF state, the output voltage of the voltage application unit 140 is not applied to the secondary battery 20. At this time, the positive electrode terminal 221 and the negative electrode terminal 222 of the secondary battery 20 are in an open state (floating state). That is, the time when the switching unit 120 is in an OFF state is the second state. In the second state, no charge flows in and out of the positive electrode terminal 221 and the negative electrode terminal 222.

In the example of Fig. 6, the voltage application unit 140 outputs a predetermined voltage $V_2$. The predetermined voltage $V_2$ is a voltage determined based on the open circuit voltage. For example, $\Delta V_2$, which is a difference between the open circuit voltage and the output voltage of the voltage application unit 140, is predetermined, and $\Delta V_2$ is subtracted from the open circuit voltage of the secondary battery 20 to be measured, thereby deciding the voltage $V_2$ with respect to the secondary battery 20. When the switching unit 120 is in an ON state, the output voltage of the voltage application unit 140 is applied to the secondary battery 20. That is, the time when the switching unit 120 is in an ON state is the first state. In the example of this figure, the secondary battery 20 is discharged in the first state. On the other hand, when the switching unit 120 is in an OFF state, the output voltage of the voltage application unit 140 is not applied to the secondary battery 20. At this time, the positive electrode terminal 221 and the negative electrode terminal 222 of the secondary battery 20 are in an open state (floating state). That is, the time when the switching unit 120 is in an OFF state is the second state. In the second state, no charge flows in and out of the positive electrode terminal 221 and the negative electrode terminal 222.

In the first state generated by the measurement apparatus 10, the secondary battery 20 may be charged as shown in Fig. 5 or the secondary battery 20 may be discharged as shown in Fig. 6.

The measurement unit 160 of the measurement apparatus 10 measures the magnetic field leaking to the outside of the secondary battery 20 in the second state. For example, the measurement unit 160 generates time-series data of the magnetic field in the second state as a measurement result. In the second state, the strength of the magnetic field measured by the measurement unit 160 approaches zero with the elapse of time from a time point when the first state is switched to the second state. The measurement unit 160 measures the transient response. In the second state following the first state, the positive electrode terminal 221 and the negative electrode terminal 222 of the secondary battery 20 are in an open state, so that no charge flows in and out of the secondary battery 20. In such a second state, the charge distribution is relaxed inside the secondary battery 20. The magnetic field is generated by the movement of the charge during the relaxation process, and the magnetic field also leaks to the outside of the secondary battery 20. The measurement unit 160 measures the leakage magnetic field. Here, how the relaxation of the charge distribution occurs depends on the distribution of electrical characteristics (impedance or the like) inside the secondary battery 20. Therefore, it can be said that the magnetic field measured by the measurement unit 160 includes information on the distribution of the electrical characteristics inside the secondary battery 20.

According to the measurement apparatus 10 according to the present embodiment, the secondary battery 20 is neither charged nor discharged in the second state. That is, the measurement is performed in a state where a current flowing through the positive electrode terminal 221 and the negative electrode terminal 222 is interrupted. The effect of this configuration will be further described. In a case where the magnetic field is measured in a state where a current flows through the electrode of the secondary battery 20, current concentration occurs in the vicinity of the positive electrode terminal 221 and the negative electrode terminal 222, and the measurement is performed in a state where a strong magnetic field is generated in the vicinity of these terminals. In order to measure such a strong magnetic field, it is necessary to increase a measurement range of the magnetic field by a sensor. On the other hand, in a large measurement range, it is difficult to measure a weak magnetic field in detail at a position away from the positive electrode terminal 221 or the negative electrode terminal 222. With respect to this, with the measurement apparatus 10 according to the present embodiment, the magnetic field is measured in a state where no current flows through the positive electrode terminal 221 and the negative electrode terminal 222. Therefore, current concentration or a strong magnetic field does not occur in the vicinity of the positive electrode terminal 221 or the negative electrode terminal 222, and the magnetic field is made more uniform as a whole than in a case where a current flows through the terminals. As a result, the magnetic field can be measured in a good measurement range throughout the secondary battery 20, and a weak magnetic field can also be measured with high accuracy.

The processing unit 180 processes the transient response measured by the measurement unit 160 to calculate a feature value of the transient response. For example, the processing unit 180 calculates a time average of the magnetic field measured by the measurement unit 160, as the feature value. Alternatively, the processing unit 180 may calculate a time constant of the transient response measured by the measurement unit 160, as the feature value. The feature value is not limited to these values, and various statistical values can be used as the feature value. As described above, in a case where the measurement unit 160 measures the transient response at the plurality of positions in one or more planes 201 outside the secondary battery 20, the processing unit 180 can generate a map indicating internal information of the secondary battery 20. The processing unit 180 generates a map showing a distribution of the calculated feature values. The map generated by the processing unit 180 can be output as an image. According to such an image, a contrast occurs between a defective portion and a normal portion inside the secondary battery 20. Accordingly, a user who has checked the image can recognize the presence or absence and a position of the defective portion.

In addition, the processing unit 180 may determine whether or not the secondary battery 20 has an abnormality by using the measurement result of the measurement unit 160. Then, the processing unit 180 may output a notification in a case where it is determined that the secondary battery 20 has an abnormality.

For example, in a case where a plurality of the secondary batteries 20 manufactured by the same method are measured, it is assumed that individual differences between the secondary batteries 20 are not large. Therefore, it is possible to compare the predetermined normal range with the calculated feature value, and determine whether or not the secondary battery 20 has an abnormality based on a comparison result. That is, in a case where the feature value is within the normal range, the processing unit 180 determines that the secondary battery 20 has no abnormality. In a case where the feature value is not within the normal range, the processing unit 180 determines that the secondary battery 20 has an abnormality. The normal range can be determined by a preliminary test or the like. The processing unit 180 can read information indicating the normal range, which is stored in a storage unit accessible from the processing unit 180, and use the information for the determination. The information indicating the normal range may be one or more threshold values indicating an end of the normal range.

In a case where the processing unit 180 calculates the feature value for a plurality of measurement positions in the plane 201, when at least one feature value among the plurality of feature values is not within the normal range, the processing unit 180 determines that the secondary battery 20 has an abnormality.

As another example, the processing unit 180 may determine whether or not the secondary battery 20 has an abnormality based on a variation (for example, a dispersion) of the plurality of feature values calculated for the plurality of measurement positions. That is, in a case where the variation in the feature value is equal to or less than a predetermined threshold value, the processing unit 180 determines that the secondary battery 20 has no abnormality. In a case where the variation in the feature value is larger than the threshold value, the processing unit 180 determines that the secondary battery 20 has an abnormality. The threshold value can be determined by a preliminary test or the like. The processing unit 180 can read information indicating the threshold value, which is stored in a storage unit accessible from the processing unit 180, and use the information for the determination.

The processing unit 180 can output the generated map or the notification indicating the determination result as output information, for example, by displaying the generated map or the notification indicating the determination result on a display provided in the processing unit 180. As another example, the processing unit 180 may output the output information to an apparatus external to the measurement apparatus 10, or may cause a storage device accessible from the processing unit 180 to store the output information. In a case where it is determined that there is an abnormality, the processing unit 180 may display, on the display, a message indicating that there is an abnormality as the notification, may output the message indicating that there is an abnormality as a voice, may output a predetermined sound, or may turn on or blink a predetermined lamp. In addition, in a case where it is determined that there is no abnormality, the processing unit 180 may output a notification different from the notification in a case where it is determined that there is an abnormality.

The measurement unit 160 may measure a plurality of transient responses (that is, a plurality of times of transient responses) at each measurement position. For example, the switching unit 120 and the voltage application unit 140 may alternately and repeatedly implement the first state and the second state, and the measurement unit 160 may measure the transient response of the magnetic field in each second state. Here, it is preferable that charging and discharging are alternately performed in a plurality of times of the first states. In other words, it is preferable that the first state in which the secondary battery 20 is charged and the first state in which the secondary battery 20 is discharged are alternately implemented. That is, the voltage $V_B$ as shown in Fig. 5 and the voltage $V_B$ as shown in Fig. 6 are alternately applied. As a result, the first state in which the secondary battery 20 is charged and the second state, and the first state in which the secondary battery 20 is discharged and the second state are repeatedly implemented in this order. In this manner, the charging or discharging does not proceed unilaterally, and the measurement can be repeatedly performed on the secondary battery 20 in substantially the same state of charge. Then, an S/N ratio can be improved by integrating or averaging the obtained plurality of measurement results. As a result, an abnormality part in the secondary battery 20 can be detected with high accuracy.

It is preferable that a balance between the charge amount and the discharge amount is maintained by repeating the plurality of times of the first state. The charge amount is quantified by a product of a length $t_c$ of the time in the first state shown in Fig. 5 and the difference $\Delta V_1$ between $V_1$ and the open circuit voltage, that is, $t_c \times \Delta V_1$. Moreover, the discharge amount is quantified by a product of a length $t_d$ of the time of the first state shown in Fig. 6 and the difference $\Delta V_2$ between $V_2$ and the open circuit voltage, that is, $t_d \times \Delta V_2$. Therefore, it is preferable that the first state and the second state are alternately repeated in a state where $t_c \times \Delta V_1 = t_d \times \Delta V_2$ is established. Lengths of the plurality of times of the first state may be the same as or different from each other. In addition, the difference between the voltage applied to the secondary battery 20 in the plurality of times of the first state and the open circuit voltage may be the same or different. Each of $t_c$ and $t_d$ is, for example, equal to or more than 0.1 seconds and equal to or less than 10 seconds. Each of $\Delta V_1$ and $\Delta V_2$ is, for example, equal to or more than 0.01 V and equal to or less than 4 V. $\Delta V_1$ and $\Delta V_2$ may be the same as or different from each other. For example, one of $\Delta V_1$ and $\Delta V_2$ may be a value obtained by adding a compensation value for compensating for asymmetry between the positive electrode and the negative electrode of the secondary battery 20 to the other of $\Delta V_1$ and $\Delta V_2$.

In addition, in a case where the first state in which the secondary battery 20 is charged and the second state, and the first state in which the secondary battery 20 is discharged and the second state are repeatedly implemented in this order as described above, the measurement unit 160 may measure both the transient response when switching from the first state in which the secondary battery 20 is charged to the second state (hereinafter, referred to as a post-charge transient response) and the transient response when switching from the first state in which the secondary battery 20 is discharged to the second state (hereinafter, referred to as a post-discharge transient response), or may measure only one of the both.

In a case where the measurement unit 160 measures a plurality of transient responses at each measurement position, the processing unit 180 calculates the feature value of the transient response for each measurement position, for example. Examples of the feature value include an average value of time averages of the magnetic fields in a plurality of transient responses, and an average value of time constants in a plurality of transient responses. Then, the processing unit 180 can generate a map showing a distribution of the calculated feature values. In addition, the processing unit 180 can determine whether or not the secondary battery 20 has an abnormality by comparing the calculated feature value with the predetermined normal range. In the calculation of the feature value, data of the post-charge transient response and data of the post-discharge transient response may be distinguished from each other or may not be distinguished from each other. In a case where these data are distinguished from each other, the feature value can be calculated for each of the data of the post-charge transient response and the data of the post-discharge transient response. In a case where the data of the post-charge transient response and the data of the post-discharge transient response are not distinguished from each other, for example, in calculating the time average of the magnetic field or the like, the strength of the magnetic field, that is, an absolute value is used.

A hardware configuration of the measurement apparatus 10 will be described. The switching unit 120, the voltage application unit 140, the processing unit 180, and the control unit 190 of the measurement apparatus 10 may be implemented by hardware (for example, an electronic circuit) that implements the switching unit 120, the voltage application unit 140, the processing unit 180, and the control unit 190, or may be implemented by a combination of hardware and software (for example, a combination of an electronic circuit and a program for controlling the electronic circuit). Hereinafter, a case where the switching unit 120, the voltage application unit 140, the processing unit 180, and the control unit 190 of the measurement apparatus 10 are implemented using a combination of hardware and software will be further described.

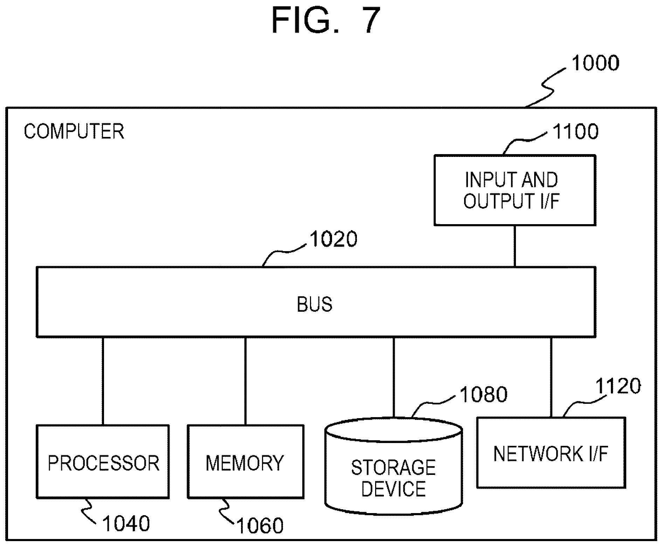

Fig. 7 is a diagram illustrating a computer 1000 for implementing the measurement apparatus 10. The computer 1000 is any computer. For example, the computer 1000 is a system on chip (SoC), a personal computer (PC), a server machine, a tablet terminal, a smartphone, or the like. The computer 1000 may be a dedicated computer designed to implement the measurement apparatus 10, or may be a general-purpose computer. In addition, the measurement apparatus 10 may be implemented using one computer 1000, or may be implemented using a combination of a plurality of computers 1000.

The computer 1000 includes a bus 1020, a processor 1040, a memory 1060, a storage device 1080, an input and output interface 1100, and a network interface 1120. The bus 1020 is a data transmission path through which the processor 1040, the memory 1060, the storage device 1080, the input and output interface 1100, and the network interface 1120 transmit and receive data to and from each other. Note that a method of connecting the processor 1040 and the like to each other is not limited to bus connection. The processor 1040 is various types of processors such as a central processing unit (CPU), a graphics processing unit (GPU), and a field-programmable gate array (FPGA). The memory 1060 is a main storage device implemented using a random access memory (RAM) or the like. The storage device 1080 is an auxiliary storage device implemented using a hard disk, a solid state drive (SSD), a memory card, a read only memory (ROM), or the like.

The input and output interface 1100 is an interface for connecting the computer 1000 to input and output devices. For example, an input device such as a keyboard or an output device such as a display is connected to the input and output interface 1100. A method of connecting the input and output interface 1100 to the input device or the output device may be a wireless connection or a wired connection.

The network interface 1120 is an interface for connecting the computer 1000 to a network. The communication network is, for example, a local area network (LAN) or a wide area network (WAN). A method of connecting the network interface 1120 to the network may be a wireless connection or a wired connection.

The storage device 1080 stores a program module for implementing each functional component of the measurement apparatus 10. The processor 1040 reads out each of these program modules into the memory 1060 and executes the program modules, thereby implementing the function corresponding to each program module.

A measurement method according to the present embodiment will be described. The measurement method according to the present embodiment is a method of measuring the secondary battery 20. In the present measurement method, the first state in which a predetermined voltage determined based on the open circuit voltage of the secondary battery 20 is applied to the secondary battery 20 and the second state in which the secondary battery 20 is open are switched. In addition, the transient response of the external magnetic field of the secondary battery 20 when switching from the first state to the second state is measured. Then, the information on the inside of the secondary battery 20 is generated using the measurement result of the transient response.

The measurement method according to the present embodiment is implemented by the measurement apparatus 10 according to the present embodiment.

According to the present embodiment, by measuring the transient response of the external magnetic field of the secondary battery when switching from the first state to the second state, it is possible to stably perform the measurement in a state where the charging or discharging is not in progress and to obtain the information on the inside of the secondary battery. In addition, the magnetic field can be measured in a good measurement range throughout the secondary battery 20, and a weak magnetic field can also be measured with high accuracy.

(Second Embodiment)

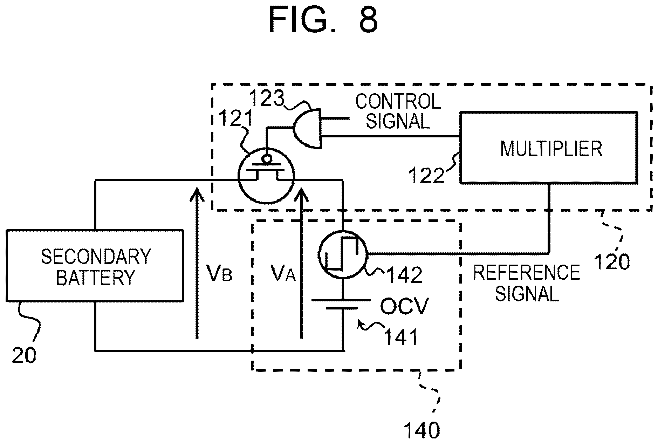

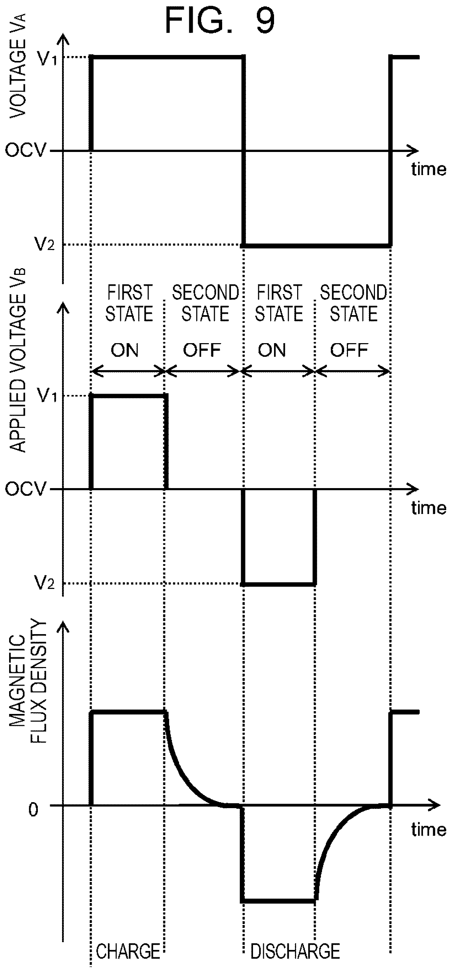

Fig. 8 is a diagram illustrating a configuration of the switching unit 120 and the voltage application unit 140 included in the measurement apparatus 10 according to a second embodiment. Fig. 9 is a diagram describing an operation of the measurement apparatus 10 according to the present embodiment. The measurement apparatus 10 and the measurement method according to the present embodiment are the same as the measurement apparatus 10 and the measurement method according to the first embodiment except for points to be described below.

In the measurement apparatus 10 according to the present embodiment, the voltage application unit 140 applies a predetermined voltage to the secondary battery 20 by using a periodic signal. The switching unit 120 switches between the first state and the second state by using a periodic signal having a frequency that is an integral multiple of a frequency of the periodic signal. The details will be described below.

In the example of Fig. 8, the voltage application unit 140 includes a DC voltage source 141 and an oscillator 142. The DC voltage source 141 is set to output a DC voltage having the same voltage value as the open circuit voltage of the secondary battery 20. The open circuit voltage of the secondary battery 20 can be separately measured prior to the measurement by the measurement apparatus 10. Then, prior to the measurement by the measurement apparatus 10, the user of the measurement apparatus 10 sets an output voltage value of the DC voltage source 141.

The oscillator 142 outputs, for example, a voltage signal of a rectangular wave. The signal output by the oscillator 142 is also referred to as a standard signal below. The DC voltage source 141 and the oscillator 142 are connected in series, and a voltage $V_A$ in which the output voltage of the DC voltage source 141 and the output voltage of the oscillator 142 are superimposed is output from the voltage application unit 140. In the first state, the output voltage $V_A$ of the voltage application unit 140 is applied between the positive electrode terminal 221 and the negative electrode terminal 222 of the secondary battery 20, so that a predetermined voltage determined based on to the open circuit voltage of the secondary battery 20 is applied to the secondary battery 20.

An upper part of Fig. 9 shows a waveform of the output voltage $V_A$ of the voltage application unit 140. The waveform of the voltage $V_A$ is a rectangular wave centered on the open circuit voltage. In other words, the waveform of the voltage $V_A$ is obtained by adding a DC offset corresponding to the open circuit voltage to the reference waveform. A frequency of the standard signal can be arbitrarily set according to characteristics of the secondary battery 20 and the like, but is, for example, equal to or more than 0.1 Hz and equal to or less than 100 kHz. In addition, an amplitude of the standard signal is, for example, equal to or more than 0.02 $V_{p-p}$ and equal to or less than 8 $V_{p-p}$. The voltage $V_1$ and the voltage $V_2$, which are peak values of the voltage $V_A$, are voltages applied to the secondary battery 20 in the first state. The secondary battery 20 is charged when the voltage $V_1$ higher than the open circuit voltage is applied. The secondary battery 20 is discharged when the voltage $V_2$ lower than the open circuit voltage is applied.

In the example of Fig. 8, the switching unit 120 includes a MOSFET 121, a multiplier 122, and an AND gate 123. An output signal of the AND gate 123 is input to a gate of the MOSFET 121. One of a source and a drain of the MOSFET 121 is connected to one output terminal of the voltage application unit 140. The other of the source and the drain of the MOSFET 121 is connected to one of the positive electrode terminal 221 and the negative electrode terminal 222 of the secondary battery 20. The other output terminal of the voltage application unit 140 is connected to the other of the positive electrode terminal 221 and the negative electrode terminal 222 of the secondary battery 20. The output terminal of the voltage application unit 140 means a terminal that outputs the voltage $V_A$.

In the example of this figure, the MOSFET 121 is a p-channel MOSFET, but the MOSFET 121 is not limited to this example, and may be an n-channel MOSFET or another switching element. A control signal from the control unit 190 and an output signal of the multiplier 122 are input to two input terminals of the AND gate 123.

The control unit 190 continues to input an "1" level signal as a control signal to the AND gate 123 during the first state or the second state (for example, during a measurement step described below in a third embodiment). Moreover, the control unit 190 continues to input a "0" level signal as a control signal to the AND gate 123 during a state other than the first state or the second state (for example, during a determination step described below in a third embodiment). In the present example, it is assumed that the "1" level signal is a negative voltage and the "0" level signal is 0 V.

A reference signal output from the oscillator 142 is input to the multiplier 122. The reference signal is a periodic signal having the same frequency as the standard signal. The multiplier 122 outputs a periodic signal (for example, a rectangular wave) having a frequency that is an integral multiple of the frequency of the reference signal.

Fig. 9 shows an example of a case where the multiplier 122 outputs a periodic signal having a frequency twice the frequency of the reference signal. In addition, in this figure, the diagram shows an example of a case where the control unit 190 continues to input an "1" level signal to the AND gate 123 as a control signal. That is, when the output of the multiplier 122 is at the "1" level, the output of the AND gate 123 is at the "1" level, and when the output of the multiplier 122 is at a level other than the "1" level, the output of the AND gate 123 is at the "0" level. As a result, the AND gate 123 outputs a signal that switches between the "1" level and the "0" level at a frequency twice the frequency of the reference signal, that is, at a frequency twice the frequency of the standard signal. The MOSFET 121 is in an ON state when the input to the gate is at the "1" level, and is in an OFF state when the input to the gate is at the "0" level. In the example of this figure, when the input to the gate of the MOSFET 121 is at the "1" level, the gate potential is negative.

As a result of these operations, the application of the voltage $V_A$ to the secondary battery 20 is turned ON and OFF at a frequency twice the frequency of the standard signal. A period in which the MOSFET 121 is in an ON state corresponds to a period of the first state, and a period in which the MOSFET 121 is in an OFF state corresponds to a period of the second state. As shown in a middle part of this figure, the first state and the second state are repeated at a frequency twice the frequency of the standard signal. In addition, in a lower part of this figure, an example of a waveform assumed as the magnetic flux density outside the secondary battery 20 is shown.

According to the measurement apparatus 10 according to the present embodiment, the first state in which the secondary battery 20 is charged and the second state, and the first state in which the secondary battery 20 is discharged and the second state are repeatedly implemented in this order. In addition, the above-described relationship of $t_c \times \Delta V_1 = t_d \times \Delta V_2$ is established. As described above in the first embodiment, the measurement unit 160 according to the present embodiment can repeatedly perform the measurement of the transient response on the secondary battery 20 in substantially the same state of charge. The processing unit 180 can obtain information with a high S/N ratio by using the measured plurality of transient responses. As a result, an abnormality part in the secondary battery 20 can be detected with high accuracy.

Note that the hardware configuration of the switching unit 120 and the voltage application unit 140 included in the measurement apparatus 10 according to the present embodiment is not limited to the example of Fig. 8.

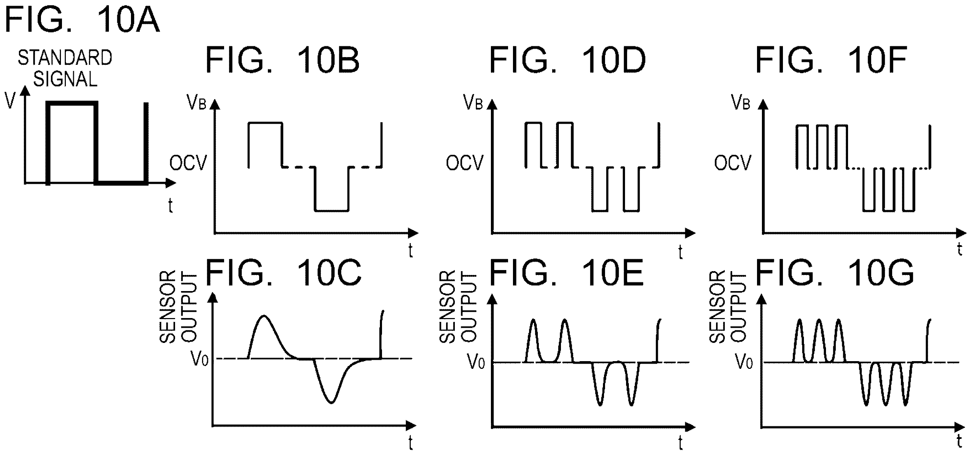

Figs.10A to 10A are diagrams showing an example of a case where the frequency of the periodic signal output by the multiplier 122 is changed. Fig. 10A shows a waveform of the standard signal. Figs. 10B and 10C respectively show the voltage $V_B$ in a case where the multiplier 122 outputs a periodic signal having a frequency twice the frequency of the reference signal, and an example of the assumed output waveform of the measurement unit 160. Figs. 10D and 10E respectively show the voltage $V_B$ in a case where the multiplier 122 outputs a periodic signal having a frequency four times the frequency of the reference signal, and an example of the assumed output waveform of the measurement unit 160. Figs. 10F and 10G respectively show the voltage $V_B$ in a case where the multiplier 122 outputs a periodic signal having a frequency six times the frequency of the reference signal, and an example of the assumed output waveform of the measurement unit 160. In broken line portions of Figs. 10B, 10D, and 10F, the secondary battery 20 is in an open state. $V_0$ in Figs. 10C, 10E, and 10G of is a sensor output value in a case where the magnetic flux density is zero.

As described above, when the multiplier 122 outputs a periodic signal having a frequency that is an even multiple of the frequency of the reference signal, the set of the first state in which the secondary battery 20 is charged and the second state continues N times, and then the set of the first state in which the secondary battery 20 is discharged and the second state continues N times. That is, the number of times of the first state in which the secondary battery 20 is charged and the number of times of the first state in which the secondary battery 20 is discharged are equal to each other. Therefore, the measurement of the transient response can be repeatedly performed in a state where the balance between the charge amount and the discharge amount is maintained. N represents an integer of 1 or more.

(Third Embodiment)

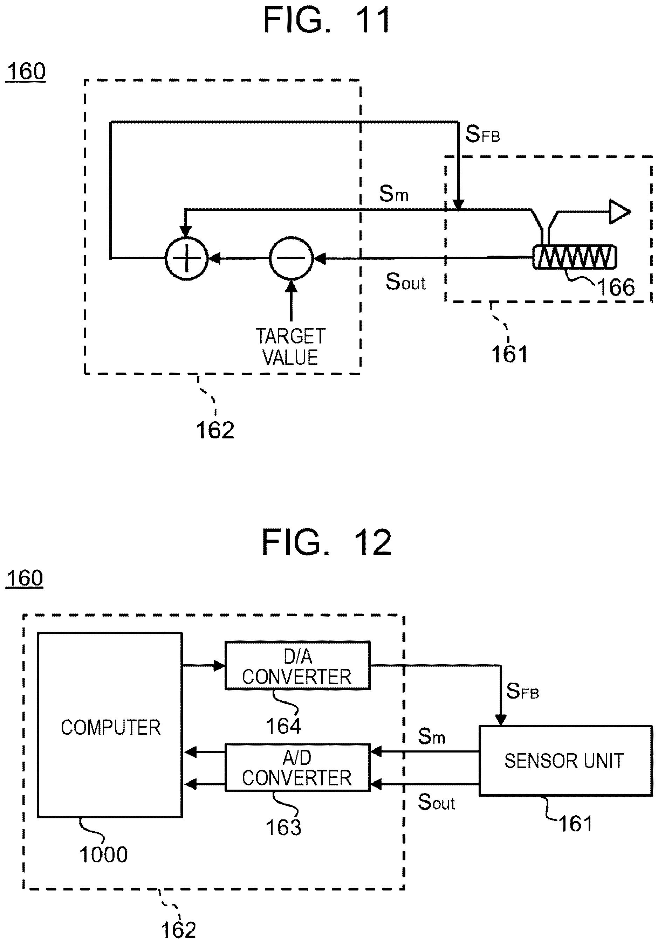

Fig. 11 is a diagram illustrating a flow of a signal in the measurement unit 160 according to a third embodiment. Fig. 12 is a diagram illustrating a hardware configuration of the measurement unit 160 according to the present embodiment. The measurement apparatus 10 according to the present embodiment is the same as the measurement apparatus 10 according to the first or second embodiment except for points to be described below. The measurement method according to the present embodiment is the same as the measurement method according to the first or second embodiment except for points to be described below.

The measurement apparatus 10 according to the present embodiment includes the control unit 190 that controls the voltage application unit 140 and the measurement unit 160. The measurement unit 160 includes the sensor unit 161 and the sensor drive unit 162. The control unit 190 controls the voltage application unit 140 and the measurement unit 160 such that a determination step and a measurement step are performed in order. In the determination step, a fixed input value to the sensor unit 161 which is used for canceling at least a part of a noise magnetic field is determined. In the measurement step, the transient response is measured in a state where the fixed input value is input to the sensor unit 161.

More specifically, in the determination step, the control unit 190 controls the voltage application unit 140 and the measurement unit 160 such that the sensor drive unit 162 performs feedback control of an input value to the sensor unit 161 so that an output of the sensor unit 161 approaches a reference level in a state where a voltage corresponding to the open circuit voltage is applied to the secondary battery 20, thereby determining the fixed input value.

The secondary battery 20 may include, for example, a ferromagnetic material as an electrode material or the like. Examples of the ferromagnetic material included in the secondary battery 20 include nickel, cobalt, and iron. Due to this ferromagnetic material, a magnetic field can be generated from the secondary battery 20 regardless of the relaxation of the charge. Such a magnetic field acts as noise in the measurement. In addition, a noise magnetic field due to a geomagnetic field or a magnetic material in the vicinity of the measurement position may also be present.

In the present embodiment, the sensor unit 161 can include any magnetic sensor such as a coil, a Hall element, an optically pumping magnet sensor, a diamond magnet sensor, a magnetic impedance sensor, or a magnetoresistance effect element. The sensor unit 161 has, for example, a core and one or two or more coils wound around the core. In the example of Fig. 11, the sensor unit 161 can receive an input signal $S_{FB}$, which is a feedback signal. A current corresponding to the input signal $S_{FB}$ flows through a coil 166 of the sensor unit 161 to generate a magnetic field. By appropriately setting the input signal $S_{FB}$, it is possible to cancel the noise magnetic field with the generated magnetic field.

The sensor unit 161 outputs a monitor signal $S_m$ indicating a level of the input signal $S_{FB}$, which is input. In addition, the sensor unit 161 outputs an output signal $S_{out}$ indicating the measured magnetic flux density.

The sensor drive unit 162 subtracts a predetermined target value from the output signal $S_{out}$ from the sensor unit 161, and adds the monitor signal $S_m$ to the obtained signal. The sensor drive unit 162 may further amplify the signal obtained after the addition. The target value corresponds to a signal value of the output signal $S_{out}$ of the sensor unit 161 when the measured magnetic flux density is zero. Such a target value is set as a reference level. The sensor drive unit 162 can perform feedback control to cancel the noise magnetic field measured by the sensor unit 161.

The hardware configuration of the measurement unit 160 will be described with reference to Fig. 12. The sensor drive unit 162 includes a D/A converter 164 and an A/D converter 163. The sensor drive unit 162 is implemented using the computer 1000. The output signal $S_{out}$ and the monitor signal $S_m$ output from the sensor unit 161 are input to the computer 1000 through the A/D converter 163. The input signal $S_{FB}$ is output from the computer 1000 and input to the sensor unit 161 through the D/A converter 164. A hardware configuration of the computer 1000 for implementing the sensor drive unit 162 is represented in, for example, Fig. 7 as with the control unit 190 and the like. Note that a program module that implements the function of the sensor drive unit 162 is further stored in the storage device 1080 of the computer 1000 for implementing the sensor drive unit 162.

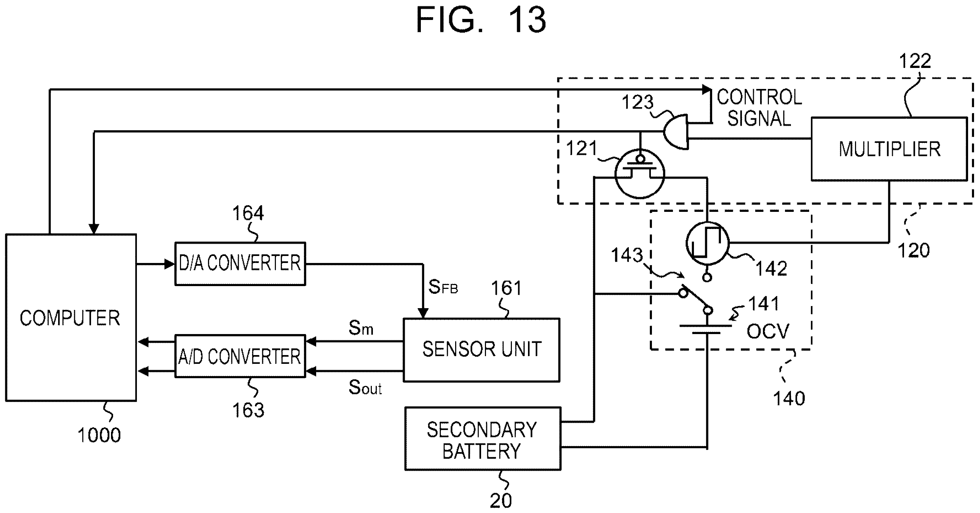

Fig. 13 is a diagram illustrating a configuration of the measurement apparatus 10 according to the present embodiment. This figure shows an example in which the switching unit 120 and the voltage application unit 140 have the same configurations as the switching unit 120 and the voltage application unit 140 of the measurement apparatus 10 according to the second embodiment, but the configurations of the switching unit 120 and the voltage application unit 140 are not limited to the present example.

As described above, the measurement apparatus 10 according to the present embodiment performs the determination step and the measurement step in this order. Specifically, at each measurement position, the determination step is performed once before the measurement step.

In the determination step, a voltage corresponding to the open circuit voltage is applied between the positive electrode terminal 221 and the negative electrode terminal 222 of the secondary battery 20 by the voltage application unit 140. The voltage application unit 140 includes, for example, a switch 143 that can be switched under the control of the control unit 190. By switching the switch 143, a state in which a voltage corresponding to the open circuit voltage is applied to the secondary battery 20 from the DC voltage source 141 and a state for the measurement step in which the first state and the second state are implemented are switched. The control unit 190 can control switching of the switch 143.

In the determination step, the feedback control by the sensor drive unit 162 is started in a state where a voltage corresponding to the open circuit voltage is applied to the secondary battery 20 from the DC voltage source 141. In a state where a voltage corresponding to the open circuit voltage is applied to the secondary battery 20, the secondary battery 20 is neither charged nor discharged, so that only the noise magnetic field is measured. Then, the control loop is repeated at a predetermined cycle until the output signal $S_{out}$ of the sensor unit 161 reaches the vicinity of a reference level which is a cancellation point of the noise magnetic field. Then, the sensor drive unit 162 ends the feedback control when the output signal $S_{out}$ falls within a predetermined range near the reference level. The sensor drive unit 162 sets the input signal (feedback signal) $S_{FB}$ at the end of the feedback control as the fixed input value. In other words, the fixed input value can be said to be a set value capable of appropriately cancelling the noise magnetic field at the measurement position. In the subsequent measurement step, the sensor drive unit 162 sets the input signal $S_{FB}$ to the sensor unit 161 to the fixed input value. The control unit 190 controls the sensor drive unit 162 such that such an operation is performed in the determination step and the measurement step.

In the measurement step, as described in the first and second embodiments, the first state and the second state are implemented, and the transient response of the magnetic field in the second state is measured by the measurement unit 160.

In the example of this figure, the switching unit 120 is controlled by a control signal from the computer 1000 having the function of the control unit 190. For example, as described in the second embodiment, the control unit 190 inputs a **"0"** level control signal to the AND gate 123 during the determination step. In addition, during the measurement step, the **"1"** level control signal is input to the AND gate 123. In addition, the control unit 190 monitors the state of switching by the switching unit 120 by monitoring the output signal of the AND gate 123. The control unit 190 specifies the period of the second state based on the monitored state of switching, and acquires the output signal $S_{out}$ of the sensor unit 161 in the period of the second state.

In the present embodiment, the operation and the effect similar to those in the first embodiment can be obtained.

In addition, measurement in which the influence of the noise magnetic field is reduced can be performed.

(Fourth Embodiment)

The measurement apparatus 10 according to a fourth example embodiment is the same as the measurement apparatus 10 according to at least any of the first to third embodiments except for points described below. The measurement method according to the present embodiment is the same as the measurement method according to at least any of the first to third embodiments except for points described below.
The measurement unit 160 of the measurement apparatus 10 according to the present embodiment measures magnetic field components in two directions orthogonal to each other as a transient response. The processing unit 180 generates a conductivity distribution inside the secondary battery 20 by using the magnetic field components in the two directions. The details will be described below.
Specifically, the measurement unit 160 measures a magnetic field component in the x direction and a magnetic field component in the y direction at a plurality of measurement points (x,y) in the plane 201 parallel to the principal surfaces of the positive electrode 211 and the negative electrode 212. The magnetic field component in the x direction means an x direction component of the magnetic flux density, and the magnetic field component in the y direction means a y direction component of the magnetic flux density.
The processing unit 180 calculates, for example, a time average of each transient response of the magnetic field component in each direction. Then, an average value of the time average is calculated as a feature value for each measurement position. As a result, for each measurement point (x,y), a feature value of the magnetic field component in the x direction
(hereinafter, referred to as an x component) and a feature value of the magnetic field component in the y direction (hereinafter, referred to as a y component) can be obtained.
The processing unit 180 further generates a conductivity distribution inside the secondary battery 20 using these feature values. As a method of generating the conductivity distribution inside the secondary battery 20, for example, the method disclosed in Patent Document 1 can be used.
Specifically, the processing unit 180 derives the conductivity distribution of the predetermined plane in the secondary battery 20 that satisfies a plurality of relational expressions for the obtained x component and y component. The predetermined plane is a plane parallel to an xy plane.
More specifically, the processing unit 180 derives a conductivity distribution represented by σ based on the following Expressions (1) to (3).
[Math 1]

$$\Delta H_x = h_T^{-1} h \partial_y \{\sigma(x,y)\varphi(x,y)\}\delta(z-z_0) - \sigma_0 h\{\partial_y \varphi(x,y)\}\delta'(z-z_0) \quad \cdots (1)$$

[Math 2]

$$\Delta H_y = -h_T^{-1} h \partial_x \{\sigma(x,y)\varphi(x,y)\}\delta(z-z_0) + \sigma_0 h\{\partial_x \varphi(x,y)\}\delta'(z-z_0) \quad \cdots (2)$$

[Math 3]

$$\partial_x^2 \varphi + \partial_y^2 \varphi = (\sigma_0 h h_T)^{-1}\sigma(x,y)\varphi(x,y) \quad \cdots (3)$$

In Expressions (1) to (3), a coordinate in the x direction is represented by x, a coordinate in the y direction is represented by y, a coordinate in the z direction is represented by z, a coordinate in the z direction of the first electrode (the positive electrode 211 or the negative electrode 212) closest to the plane 201 is represented by $z_0$, an x component is represented by $H_x$, a y component is represented by $H_y$, a thickness of the first electrode in the z direction is represented by h, a distance between a pair of electrodes including the first electrode is represented by $h_T$, a conductivity of the first electrode is represented by $\sigma_0$, a potential distribution is represented by

[Math 4]

$$\varphi$$

, a delta function is represented by $\delta$, a differential of the delta function is represented by $\delta'$, a partial differential with respect to x is represented by $\partial_x$, and a partial differential with respect to y is represented by $\partial_y$.

The processing unit 180 can derive the conductivity distribution by using various mathematical expressions derived from Expressions (1) to (3).

The processing unit 180 can output the obtained conductivity distribution as, for example, an image. The processing unit 180 can output the generated image as output information, for example, by displaying the generated image on a display provided in the processing unit 180. As another example, the processing unit 180 may output the output information to an apparatus external to the measurement apparatus 10, or may cause a storage device accessible from the processing unit 180 to store the output information.

In the present embodiment, the operation and the effect similar to those in the first embodiment can be obtained. In addition, the conductivity distribution in the secondary battery 20 can be understood.

Examples

Hereinafter, the present embodiment will be described in detail with reference to Examples. The present embodiment is not limited to the description of Examples.

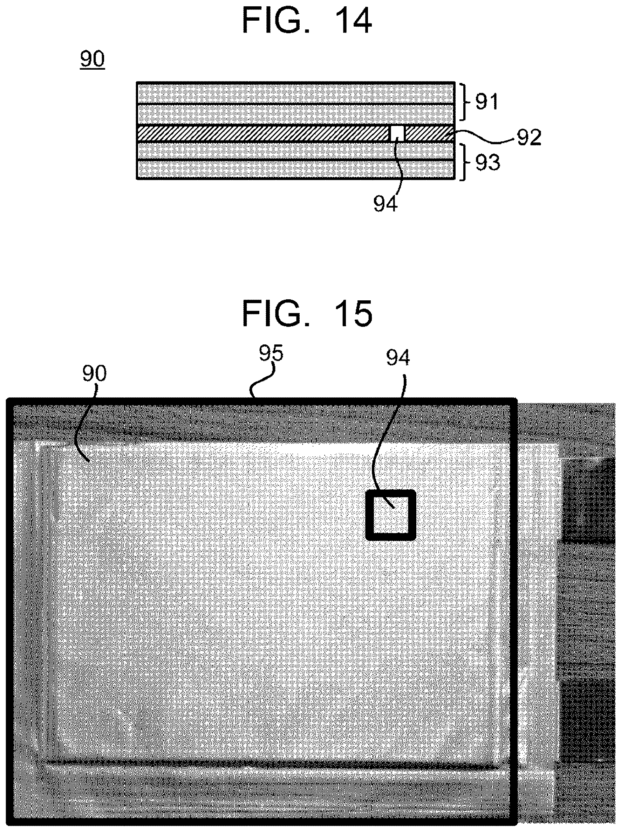

Fig. 14 is a schematic cross-sectional view showing a structure of a secondary battery 90 as a measurement target. The secondary battery 90 was measured by the method described in the third embodiment. The secondary battery 90 included a stacked body of a negative electrode 91, a separator 92, and a positive electrode 93, and the stacked body was covered with a package. In this figure, the package is not shown. As shown in this figure, a secondary battery obtained by forming a hole in a separator 92 as a defect 94 was used as a secondary battery 90 to be measured. By forming a hole in the separator 92, the positive electrode 93 and the negative electrode 91 were physically brought into contact with each other and shortcircuited at the defect 94.

Fig. 15 is a diagram showing a measurement area 95 and a position of the defect 94 with respect to a photograph of the secondary battery 90. The measurement area was set to 120 mm $\times$ 100 mm to obtain a map of 16 $\times$ 12 pixels. The integrated time at each measurement position was set to 200 sec. In addition, a frequency of the standard signal was set to 4 Hz, and a current flowing through the secondary battery 90 in the charge and discharge in the measurement step was set to 500 mA, ,. The amount of voltage drop of the secondary battery 90 due to spontaneous discharge was 1.5 mV/day (from a state of being fully charged to 3.67 V).

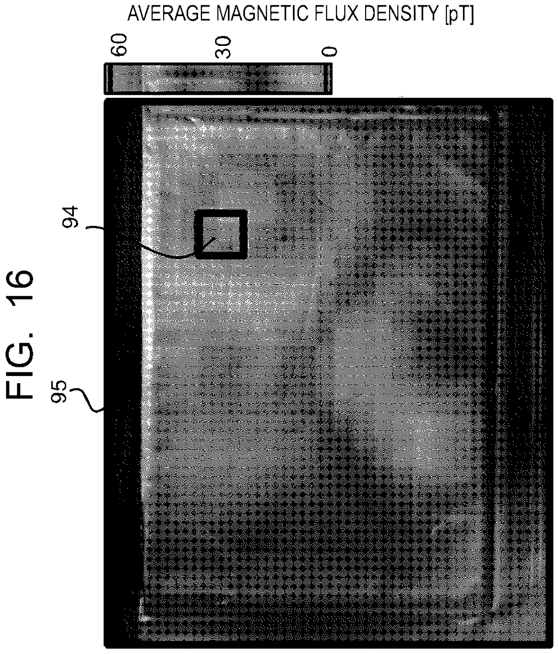

Fig. 16 is a diagram showing a map generated using measurement results of a transient response of a magnetic field. In generating this map, an absolute value of a time average of the magnetic flux density of the measured transient response was calculated for each measurement position. Then, an average value of the absolute values calculated for a plurality of times of the transient responses (referred to as an average magnetic flux density in Fig. 16 and hereinafter) was calculated. The distribution of the calculated average magnetic flux density was shown in a map. In generating this map, the average value was calculated using the data of the post-charge transient response and the data of the post-discharge transient response without distinction. In this figure, the map is shown by being superimposed on the photograph of the secondary battery 90 in a corresponding position.

As shown in this figure, in the vicinity of the defect 94, the average magnetic flux density at a level different from that in the other regions was measured. Specifically, the average magnetic flux density was higher in the vicinity of the defect 94 than in the other regions. From this result, it was confirmed that information on the inside of the secondary battery 90 can be obtained by the present measurement method and a defect can be detected.

Although the embodiments of the present invention have been described above with reference to the drawings, these are examples of the present invention, and various configurations other than those described above can be adopted. In addition, the above embodiments can be combined as long as the contents do not conflict with each other.

This application claims priority based on Japanese Patent Application No. 2022-109689 filed on July 7, 2022, and the disclosure of which is incorporated herein in its entirety by reference.

REFERENCE SIGNS LIST

10      measurement apparatus
20      secondary battery
120     switching unit

| 121 | MOSFET |
| 122 | multiplier |
| 123 | AND gate |
| 140 | voltage application unit |
| 141 | DC voltage source |
| 142 | oscillator |
| 143 | switch |
| 150 | stage |
| 160 | measurement unit |
| 161 | sensor unit |
| 162 | sensor drive unit |
| 180 | processing unit |
| 190 | control unit |
| 211 | positive electrode |
| 212 | negative electrode |
| 221 | positive electrode terminal |
| 222 | negative electrode terminal |
| 230 | electrolyte |
| 240 | package |
| 1000 | computer |

**Claims**

1. A measurement apparatus that measures a secondary battery, comprising:

   a voltage application unit that applies a predetermined voltage that is determined based on an open circuit voltage of the secondary battery, to the secondary battery;
   a switching unit that switches between a first state in which the predetermined voltage is applied to the secondary battery and a second state in which the secondary battery is open;
   a measurement unit that measures a transient response of an external magnetic field of the secondary battery when switching from the first state to the second state; and
   a processing unit that generates information on an inside of the secondary battery by using a measurement result of the measurement unit.

2. The measurement apparatus according to Claim 1, further comprising:

   a control unit that controls the voltage application unit and the measurement unit,
   wherein the measurement unit includes a sensor unit and a sensor drive unit, and
   the control unit controls the voltage application unit and the measurement unit such that a determination step of determining a fixed input value to the sensor unit which is used for canceling at least a part of a noise magnetic field and a measurement step of measuring the transient response in a state where the fixed input value is input to the sensor unit are performed in this order.

3. The measurement apparatus according to Claim 2,
   wherein, in the determination step, the control unit controls the voltage application unit and the measurement unit such that the sensor drive unit performs feedback control of an input value to the sensor unit so that an output of the sensor unit approaches a reference level in a state where a voltage corresponding to the open circuit voltage is applied to the secondary battery, thereby determining the fixed input value.

4. The measurement apparatus according to Claim 2 or 3,
   wherein the secondary battery includes a ferromagnetic material.

5. The measurement apparatus according to any one of Claims 1 to 4,

   wherein the measurement unit measures the transient response at a plurality of positions in one or more planes outside the secondary battery, and
   the processing unit generates a map indicating internal information of the secondary battery.

6. The measurement apparatus according to Claim 5,
wherein the measurement unit includes a plurality of sensor elements arranged in a matrix.

7. The measurement apparatus according to any one of Claims 1 to 6,

   wherein the processing unit
   determines whether or not the measured secondary battery has an abnormality by using the measurement result of the measurement unit, and
   outputs a notification in a case where it is determined that the secondary battery has an abnormality.

8. The measurement apparatus according to any one of Claims 1 to 7,

   wherein the voltage application unit applies the predetermined voltage to the secondary battery by using a periodic signal, and
   the switching unit switches between the first state and the second state by using a periodic signal having a frequency that is an integral multiple of a frequency of the periodic signal used by the voltage application unit.

9. The measurement apparatus according to any one of Claims 1 to 8,

   wherein the measurement unit measures magnetic field components in two directions orthogonal to each other as the transient response, and
   the processing unit generates a conductivity distribution inside the secondary battery by using the magnetic field components in the two directions.

10. A measurement method of measuring a secondary battery, comprising:

    switching between a first state in which a predetermined voltage that is determined based on an open circuit voltage of the secondary battery is applied to the secondary battery and a second state in which the secondary battery is open;
    measuring a transient response of an external magnetic field of the secondary battery when switching from the first state to the second state; and
    generating information on an inside of the secondary battery by using a measurement result of the transient response.

# FIG. 1

FIG. 2

# FIG. 3

# FIG. 4

# FIG. 5

APPLIED VOLTAGE $V_B$

FIRST STATE | SECOND STATE
ON | OFF

$V_1$

$\Delta V_1$

OCV

time

CHARGE
$t_c$

MAGNETIC FLUX DENSITY

0

time

# FIG. 6

APPLIED VOLTAGE V$_B$

FIRST STATE
ON

SECOND STATE
OFF

OCV

$\Delta V_2$

time

V$_2$

DISCHARGE
t$_d$

MAGNETIC FLUX DENSITY

0

time

# FIG. 7

# FIG. 8

# FIG. 9

VOLTAGE V_A

V₁

OCV

time

V₂

APPLIED VOLTAGE V_B

| FIRST STATE | SECOND STATE | FIRST STATE | SECOND STATE |
| ON | OFF | ON | OFF |

V₁

OCV

time

V₂

MAGNETIC FLUX DENSITY

0

time

CHARGE

DISCHARGE

FIG. 10A

STANDARD
SIGNAL

FIG. 10B

FIG. 10D

FIG. 10F

FIG. 10C

FIG. 10E

FIG. 10G

EP 4 553 521 A1

# FIG. 11

160

$S_{FB}$

$S_m$

$S_{out}$

166

161

TARGET
VALUE

162

# FIG. 12

160

| COMPUTER | | D/A CONVERTER |
| --- | --- | --- |

$S_{FB}$

164

$S_m$

A/D CONVERTER

SENSOR UNIT

$S_{out}$

163

161

1000

162

# FIG. 13

EP 4 553 521 A1

# FIG. 14

# FIG. 15

# FIG. 16

AVERAGE MAGNETIC FLUX DENSITY [pT]

## INTERNATIONAL SEARCH REPORT

| International application No. |
|---|
| **PCT/JP2023/024264** |

**A. CLASSIFICATION OF SUBJECT MATTER**

*G01R 31/389*(2019.01)i; *G01N 27/72*(2006.01)i; *G01R 33/02*(2006.01)i; *H01M 10/48*(2006.01)i
FI:   G01R31/389; H01M10/48 Z; G01N27/72; G01R33/02 K

According to International Patent Classification (IPC) or to both national classification and IPC

**B. FIELDS SEARCHED**

Minimum documentation searched (classification system followed by classification symbols)

G01R31/389; G01N27/72; G01R33/02; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2015/136930 A1 (NATIONAL UNIVERSITY CORPORATION KOBE UNIV.) 17 September 2015 (2015-09-17)<br>        entire text, all drawings | 1-10 |
| A | WO 2015/136931 A1 (NATIONAL UNIVERSITY CORPORATION KOBE UNIV.) 17 September 2015 (2015-09-17)<br>        entire text, all drawings | 1-10 |
| A | JP 2014-89819 A (HITACHI MAXELL, LTD.) 15 May 2014 (2014-05-15)<br>        abstract, paragraphs [0021]-[0026] | 1-10 |
| A | JP 2016-197054 A (UNIV. OF TOKYO) 24 November 2016 (2016-11-24)<br>        entire text, all drawings | 1-10 |
| A | WO 2021/024859 A1 (INTEGRAL GEOMETRY SCIENCE INC.) 11 February 2021 (2021-02-11)<br>        entire text, all drawings | 1-10 |

☑ Further documents are listed in the continuation of Box C.      ☑ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **11 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

| International application No. |
| --- |
| **PCT/JP2023/024264** |

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2017/187791 A1 (NATIONAL UNIVERSITY CORP. KOBE UNIV.) 02 November 2017 (2017-11-02)<br>entire text, all drawings | 1-10 |
| A | JP 2012-242153 A (PULSTEC INDUSTRIAL CO., LTD.) 10 December 2012 (2012-12-10)<br>entire text, all drawings | 1-10 |

Form PCT/ISA/210 (second sheet) (January 2015)

## INTERNATIONAL SEARCH REPORT
### Information on patent family members

| | International application No. |
|---|---|
| | **PCT/JP2023/024264** |

| Patent document cited in search report | | | Publication date (day/month/year) | Patent family member(s) | Publication date (day/month/year) |
|---|---|---|---|---|---|
| WO | 2015/136930 | A1 | 17 September 2015 | (Family: none) | |
| WO | 2015/136931 | A1 | 17 September 2015 | US 2017/0016963 A1 entire text, all drawings | |
| JP | 2014-89819 | A | 15 May 2014 | (Family: none) | |
| JP | 2016-197054 | A | 24 November 2016 | (Family: none) | |
| WO | 2021/024859 | A1 | 11 February 2021 | US 2022/0349943 A1 entire text, all drawings EP 4012819 A1 CN 114207455 A KR 10-2022-0041830 A | |
| WO | 2017/187791 | A1 | 02 November 2017 | US 2019/0120796 A1 entire text, all drawings EP 3450970 A1 | |
| JP | 2012-242153 | A | 10 December 2012 | (Family: none) | |

Form PCT/ISA/210 (patent family annex) (January 2015)

**EP 4 553 521 A1**

**Patent documents cited in the description**

- WO 2015136931 A
- WO 2015136930 A
- JP 2022109689 A